# EUROPEAN PATENT APPLICATION

(11) **EP 4 726 979 A1**
(43) Date of publication of application: **15.04.2026**
(21) Application number: 24923208.3
(22) Date of filing: 10.07.2024
(51) Int. Cl.: H02K 41/02, H02K 1/22, H02K 15/00, G02B 7/04, G03B 13/34, C23C 14/12, C23C 14/10, C23C 14/24, C23C 14/02, C23C 14/54, C09D 171/00, H04N 23/50, C10M 107/50, C10N 50/00

(54) **MOTOR, CAMERA ASSEMBLY, AND ELECTRONIC DEVICE**

(30) Priority: 07.02.2024 CN 202410174254
(71) Applicant: Huawei Technologies Co., Ltd., Shenzhen, Guangdong 518129 (CN)
(72) Inventor: CHEN, Xiaolu, Shenzhen, Guangdong 518129 (CN); CHEN, Hong, Shenzhen, Guangdong 518129 (CN); LIU, Bin, Shenzhen, Guangdong 518129 (CN); ZHONG, Yiliang, Shenzhen, Guangdong 518129 (CN)
(74) Representative: Goddar, Heinz J.
(86) International application number: PCT/CN2024/104830
(87) International publication number: WO 2025/166990

(57) **Abstract**

This application provides a motor, a camera assembly, and an electronic device. The motor in this application includes a motor stator and a motor rotor. The motor rotor includes a sliding slot and a sliding member that is at least partially located in the sliding slot. A surface of the sliding slot and/or a surface of the sliding member serve/serves as a bonding surface, a lubricating film layer is provided on the bonding surface, and composition of the lubricating film layer includes perfluoropolyether silane. The perfluoropolyether silane has excellent lubrication performance and abrasion resistance, and the formed lubricating film layer has low surface energy, so that the sliding member has lower sliding resistance with a smoother effect of sliding on the surface of the sliding slot, thereby reducing friction resistance of the motor.

## Description

This application claims priority to Chinese Patent Application No. 202410174254.9, filed with the China National Intellectual Property Administration on February 7, 2024 and entitled "MOTOR, CAMERA ASSEMBLY, AND ELECTRONIC DEVICE", which is incorporated herein by reference in its entirety.

### TECHNICAL FIELD

This application relates to the field of communication technologies, and in particular, to a motor, a camera assembly, and an electronic device.

### BACKGROUND

A contact motor, as an important part of a camera, drives a component to move a lens to perform corresponding photographing work. For a conventional contact motor, mostly a slot is disposed between a lens carrier and a housing, and then a ball or a sliding shaft is installed in the slot to reduce a friction force during movement of the lens carrier, thereby reducing power consumption during movement of the carrier. However, with development of optical performance of the camera, a lens module is increasingly heavy, a magnetic thrust required for the motor to drive the heavier lens is greater, and accordingly power consumption is much higher. Therefore, it is hoped that the motor can reduce friction resistance while maintaining an original size, thereby reducing the required magnetic thrust, decreasing a drive current, and reducing power consumption of the camera.

The friction resistance of the motor may be reduced by applying a lubricant to the sliding shaft/ball of the motor and a friction interface of the corresponding sliding slot. Currently, there are mainly two manners of applying the lubricant. One manner is a solution of performing immersion in lubricating oil to apply the lubricating oil. Specifically, the lubricating oil is accommodated in a container; and then the sliding shaft or ball is immersed in batches in the lubricating oil, taken out later, air-dried, and manually assembled onto the sliding slot of a motor assembly after the lubricating oil fully volatilizes to form a film. The other manner is a solution of dispensing or brushing the lubricating oil. Specifically, after the sliding shaft or ball is assembled onto the corresponding sliding slot, a dispenser is employed to apply the lubricating oil or a brush is employed to apply dry-film lubricating oil. However, the foregoing lubrication solutions are affected by the manners of applying the lubricant, and uniform distribution of film layers cannot be ensured after the lubricant forms the film. In an ideal friction state, a friction coefficient of the interface at a minimum can reach only a friction coefficient of the lubricant itself, and a lubrication effect of the motor cannot meet the needs of the increasingly-heavy lens module.

Therefore, how to reduce the friction resistance of the motor is still an urgent technical issue to be resolved in this field.

### SUMMARY

This application provides a motor, a camera assembly, and an electronic device. The motor in this application has low friction resistance, and a magnetic thrust required for driving a lens is smaller, so that power consumption of the camera assembly including the motor is lower.

A motor is provided, including a motor stator and a motor rotor. The motor rotor includes a sliding slot and a sliding member that is at least partially located in the sliding slot, a surface of the sliding slot and/or a surface of the sliding member serve/serves as a bonding surface, a lubricating film layer is provided on the bonding surface, and composition of the lubricating film layer includes perfluoropolyether silane.

In an optional implementation, the lubricating film layer includes a first film layer and a second film layer that are provided in a laminated manner, the first film layer is provided on a surface of the bonding surface, and the second film layer is provided on a surface of the first film layer.

The first film layer is a silicon dioxide layer, and the second film layer is a perfluoropolyether silane layer.

In an optional implementation, a thickness of the first film layer is 10 to 25 nm.

In an optional implementation, a thickness of the second film layer is 20 to 45 nm.

In an optional implementation, a D50 particle size of silicon dioxide in the first film layer is 1 to 3 mm.

According to a second aspect of this application, a method for preparing the foregoing motor is provided and includes the following step:
in a vacuum condition, performing evaporation deposition of a raw material including the perfluoropolyether silane on the bonding surface to form the lubricating film layer.

In an optional implementation, the evaporation deposition is performed at a vacuum degree of 1.0×10⁻³ to 3.0×10⁻³ Pa.

In an optional implementation, the raw material further includes silicon dioxide, and performing evaporation deposition of the raw material including the perfluoropolyether silane on the bonding surface to form the lubricating film layer includes the following steps:
heating the silicon dioxide by using a first evaporation source for the silicon dioxide to evaporate and form silicon dioxide gas molecules, and depositing the silicon dioxide gas molecules on the bonding surface to form the first film layer;
heating the perfluoropolyether silane by using a second evaporation source for the perfluoropolyether silane to evaporate and form perfluoropolyether silane gas molecules, and depositing the perfluoropolyether silane gas molecules on the surface of the first film layer to form the second film layer; and
forming the lubricating film layer by the first film layer and the second film layer together.

In an optional implementation, an evaporation rate of the silicon dioxide is 2 to 8 Å/s.

In an optional implementation, an evaporation rate of the perfluoropolyether silane is 3 to 10 Å/s.

According to a third aspect of this application, a camera assembly is provided, including the motor provided according to the first aspect of this application.

According to a fourth aspect of this application, an electronic device is provided, including the camera assembly provided according to the third aspect of this application.

This application provides a motor, including a motor stator and a motor rotor. The motor rotor includes a sliding slot and a sliding member that is at least partially located in the sliding slot. A surface of the sliding slot and/or a surface of the sliding member serve/serves as a bonding surface, a lubricating film layer is provided on the bonding surface, and composition of the lubricating film layer includes perfluoropolyether silane. The perfluoropolyether silane has excellent lubrication performance and abrasion resistance, and the formed lubricating film layer has low surface energy, so that the sliding member has lower sliding resistance with a smoother effect of sliding on the surface of the sliding slot, thereby reducing friction resistance of the motor, decreasing a magnetic thrust required for the motor to drive a lens, decreasing a drive current, and ultimately reducing power consumption of the camera assembly.

### BRIEF DESCRIPTION OF DRAWINGS

To describe the implementations in embodiments of this application or in the prior art more clearly, the following briefly introduces the accompanying drawings for describing embodiments or the prior art. It is clear that the accompanying drawings in the following description show some embodiments of this application, and a person of ordinary skill in the art may still derive other drawings from these accompanying drawings.
FIG. 1 is a diagram of contact between a sliding slot and a sliding member before a lubricating film layer is provided;
FIG. 2 is a diagram of contact between a sliding slot and a sliding member after a lubricating film layer is provided according to this application;
FIG. 3 is a sectional view of a motor stator and a motor rotor according to an embodiment of this application;
FIG. 4 is a sectional view of a motor stator and a motor rotor according to another embodiment of this application;
FIG. 5 is a perspective view of a structure of a motor stator and a motor rotor according to still another embodiment of this application;
FIG. 6 is a diagram of a structure of a lubricating film layer provided by using a surface of a sliding slot as a bonding surface according to an embodiment of this application;
FIG. 7 is a diagram of a structure of a sliding slot without surface treatment;
FIG. 8 is a diagram of a structure of a sliding slot after a first film layer is formed through evaporation deposition;
FIG. 9 is a flowchart of a method for preparing a lubricating film layer according to an embodiment of this application;
FIG. 10 is a diagram of an evaporation deposition process of a lubricating film layer and a process of assembly of a sliding member and a sliding slot according to an embodiment of this application;
FIG. 11 is a qualitative test diagram of surface energy of a lubricating film layer according to Embodiment 1 of this application;
FIG. 12 is a qualitative test diagram of surface energy of a lubricating film layer in Comparative Example 1 according to this application;
FIG. 13 is a qualitative test diagram of surface energy of a surface of a sliding slot in Comparative Example 2 according to this application; and
Figure 14 is a qualitative test diagram of surface energy of a surface of a sliding slot without lubrication treatment.

### Reference numerals:

10: motor rotor;
11: sliding slot;
12: sliding member;
13: lubricating film layer;
13a: first film layer;
13b: second film layer;
20: motor stator;
21: fixing slot;
30: motor assembly;
40: jig;
50: vacuum coating machine.

### DESCRIPTION OF EMBODIMENTS

To make the objectives, technical solutions, and advantages of this application clearer, the following clearly and completely describes the technical solutions in embodiments of this application with reference to embodiments of this application. It is clear that the described embodiments are a part rather than all of embodiments of this application. All other embodiments obtained by a person of ordinary skill in the art based on embodiments of this application without creative efforts shall fall within the protection scope of this application.

According to a first aspect of embodiments of this application, a motor is provided, including a motor stator and a motor rotor. The motor rotor includes a sliding slot and a sliding member that is at least partially located in the sliding slot, a surface of the sliding slot and/or a surface of the sliding member serve/serves as a bonding surface, a lubricating film layer is provided on the bonding surface, and composition of the lubricating film layer includes perfluoropolyether silane.

The perfluoropolyether silane is a polymer obtained after perfluoropolyether (PFPE) is coupled with siloxane, where one end is the PFPE and the other end is the siloxane. A structure of the perfluoropolyether silane may be represented by PFPE-Si(OR)₃, where R represents alkyl, for example, may be methyl or ethyl.

The PFPE includes four types: a D type, a K type, a Y type, and a Z type. A molecular structure of D-type PFPE is C₃F₇O(CF₂CF₂CF₂O)ₓC₂F₅. A molecular structure of K-type PFPE is C₃F₇O[CF(CF₃)CF₂O]ₓC₂F₅. A molecular structure of Y-type PFPE is CF₃O[CF(CF₃)CF₂O]ₓ(CF₂O)_{y}CF₃. A molecular structure of Z-type PFPE is CF₃O(CF₂CF₂CF₂O)ₓ(CF₂O)_{y}CF₃.

The siloxane includes, but is not limited to, monomethyl siloxane and/or dimethyl siloxane.

In the perfluoropolyether silane, a perfluoropolyether portion forms an outward film layer with low surface energy to provide a lubrication effect, and a siloxane portion is bonded with a base material of the bonding surface through an -Si-O- bond to generate a strong bonding force, thereby enhancing abrasion resistance of the lubricating film layer. In addition, compared with other types of organic fluorine lubricants such as polytetrafluoroethylene, the perfluoropolyether silane has better high-temperature resistance, radiation resistance and chemical stability. In this application, the lubricating film layer includes the perfluoropolyether silane, so that there is lower sliding resistance with a smoother sliding effect when the sliding slot and the sliding member slide relative to each other, thereby reducing friction resistance of the motor.

The inventor finds through research that, an oil-based marker may be used to draw lines on the lubricating film layer on the surface of the sliding slot, to determine surface energy of the film layer by observing ink marks on the film layer. Specifically, when lines are drawn on the surface of the lubricating film layer by using the oil-based marker, if ink marks do not shrink and continuous oil-based ink marks appear, it indicates that the surface energy of the lubricating film layer is high; or when lines are drawn on the surface of the lubricating film layer by using the oil-based marker, if ink shrinks and only discontinuous dotted oil-based ink marks appear or even no oil-based ink marks are left after marking, it indicates that the surface energy of the lubricating film layer is low, where the low surface energy of the lubricating film layer helps reduce friction resistance of the motor.

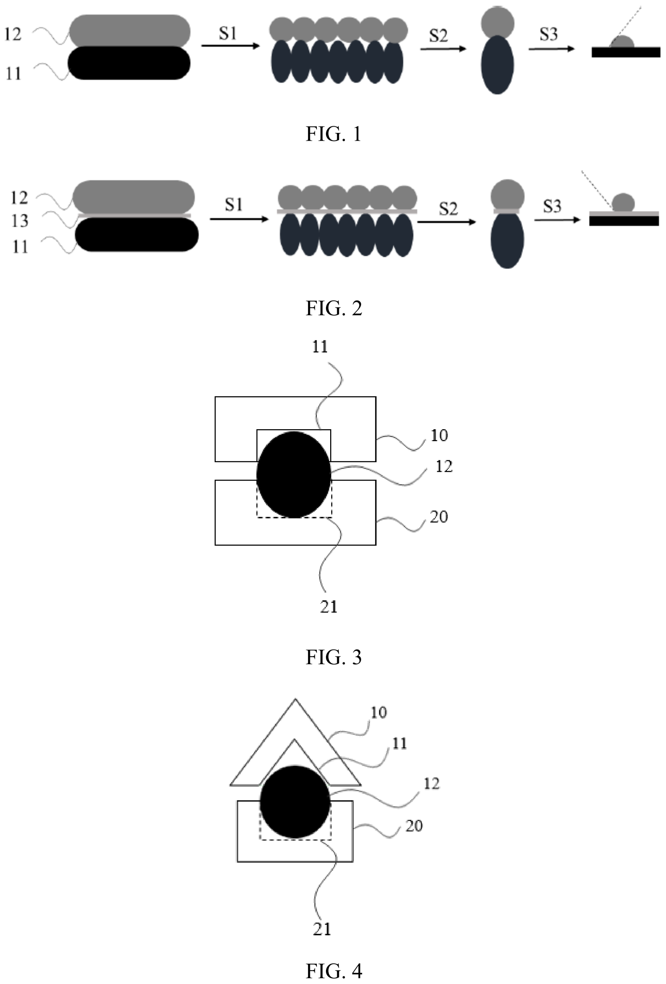

FIG. 1 is a diagram of contact between a sliding slot and a sliding member before a lubricating film layer is provided. FIG. 2 is a diagram of contact between a sliding slot and a sliding member after a lubricating film layer is provided according to this application. As shown in FIG. 1 and FIG. 2, after decomposition is performed in step S1, a sliding slot 11 and a sliding member 12 that are in contact in a macro state are decomposed into N sliding slot molecules and N sliding member molecules that are in a state of being in contact with each other. After decomposition is further performed in step S2, a contact state between a single sliding slot molecule and a single sliding member molecule can be learned. Finally, after decomposition is performed in step S3, a micro contact state between the sliding slot molecule and the sliding member molecule can be learned. When the sliding slot 11 and the sliding member 12 slide relative to each other, a friction force opposite to a sliding direction is generated. It can be learned from comparison between diagrams that are obtained after the decomposition in step S3 in FIG. 1 and FIG. 2 that: Before a lubricating film layer 13 is provided, a surface of the sliding slot 11 has good adhesion, molecular attraction between the sliding slot 11 and the sliding member 12 is strong, a contact area between the sliding slot 11 and the sliding member 12 is large, a contact angle is present as an acute angle, surface energy is high, and a friction force generated between the sliding slot 11 and the sliding member 12 is strong; and after the lubricating film layer 13 is provided, the surface of the sliding slot 11 has poor adhesion, the molecular attraction between the sliding slot 11 and the sliding member 12 is weak, the contact area between the sliding slot 11 and the sliding member 12 is small, the contact angle is present as an obtuse angle, the surface energy is low, and the friction force generated between the sliding slot 11 and the sliding member 12 is weak. Therefore, it can be learned that the friction resistance of the motor can be significantly reduced after the lubricating film layer is provided according to this application.

FIG. 3 is a sectional view of a motor stator and a motor rotor according to an embodiment of this application. FIG. 4 is a sectional view of a motor stator and a motor rotor according to another embodiment of this application. As shown in FIG. 3 and FIG. 4, a motor includes a motor rotor 10 and a motor stator 20. The motor rotor 10 includes a sliding slot 11 and a sliding member 12 that is at least partially located in the sliding slot 11. A surface of the sliding slot 11 and/or a surface of the sliding member 12 serve/serves as a bonding surface, and a lubricating film layer is provided on the bonding surface.

The lubricating film layer in this application may be provided only on the surface of the sliding slot 11 or only on the surface of the sliding member 12, or may be provided on both the surface of the sliding slot 11 and the surface of the sliding member 12.

A shape arranged for the sliding slot is not particularly limited in this application, and the sliding slot may be a U-shaped slot or a V-shaped slot commonly used in the art. As shown in FIG. 3, the shape of the sliding slot is a U-shaped. As shown in FIG. 4, the shape of the sliding slot is a V-shaped.

The sliding slot in the motor rotor is usually made of a plastic material, where the plastic material may be more easily bonded with perfluoropolyether silane to form a lubricating film layer with good uniformity and low surface energy.

A type of the sliding member is not limited in this application either. The sliding member may be a ball or a sliding shaft. A material of the ball may be metal or ceramic, and a material of the sliding shaft may be metal, ceramic, or plastic. The inventor finds through research that, when the material of the sliding shaft is plastic, providing the lubricating film layer on the surface of the sliding shaft is more conducive to reducing surface energy of the sliding shaft and can further reduce friction resistance of the motor.

As shown in FIG. 3 and FIG. 4, the motor stator 20 includes a fixing slot 21 that is disposed opposite to the sliding slot 11. The fixing slot 21 is configured to fasten the sliding member 12, and the sliding member 12 is partially located outside the fixing slot 21. The sliding member 12 located outside the fixing slot 21 may be in contact with the sliding slot 11 and slide on the sliding slot 11.

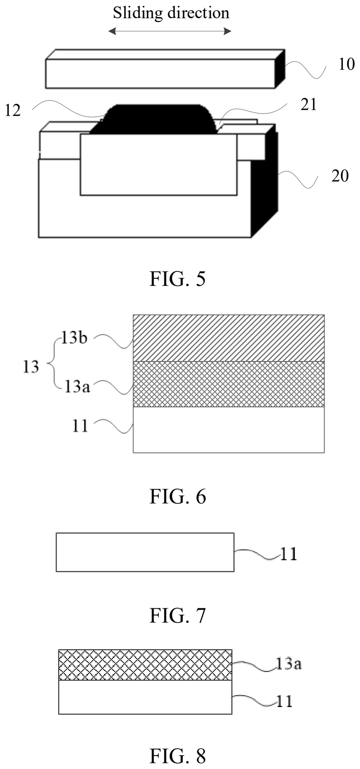

FIG. 5 is a perspective view of a structure of a motor stator and a motor rotor according to an embodiment of this application. As shown in FIG. 5, a sliding member 12 is clamped and fastened in a fixing slot 21, and a portion of the sliding member 12 protrudes from a surface of a motor stator 20. When a motor rotor 10 moves horizontally, the portion of the sliding member 12 protruding from the motor stator 20 is in contact with a sliding slot of the motor rotor 10, and slides on a surface of the sliding slot.

In a preferred implementation, the lubricating film layer includes a first film layer and a second film layer that are provided in a laminated manner. The first film layer is provided on a surface of a bonding surface, and the second film layer is provided on a surface of the first film layer. The first film layer is a silicon dioxide layer, and the second film layer is a perfluoropolyether silane layer.

FIG. 6 is a diagram of a structure of a lubricating film layer provided by using a surface of a sliding slot as a bonding surface according to an embodiment of this application. As shown in FIG. 6, a lubricating film layer 13 is provided on a surface of a sliding slot 11, and the lubricating film layer 13 includes a first film layer 13a and a second film layer 13b that are provided in a laminated manner. The first film layer 13a is provided on the surface of the sliding slot 11, and the second film layer 13b is provided on a surface of the first film layer 13a.

In the foregoing implementation, the perfluoropolyether silane layer is an outermost layer, and provides a sliding interface with low surface energy for the sliding slot and the sliding member. The silicon dioxide layer may serve as a transition layer. Silicon dioxide has a silicon hydroxyl bond, which provides a stronger force for bonding with a base material of the sliding slot and is connected to perfluoropolyether silane in the perfluoropolyether silane layer in a chemical bonding manner shown in a formula I, to generate a strong bonding force, so that connection between the lubricating film layer and the bonding surface is more reliable.

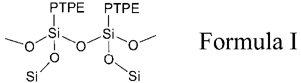

A particle size of the silicon dioxide also affects a bonding force of the first film layer. A smaller particle size of the silicon dioxide helps the first film layer to have a large specific surface area, and improves efficiency of space filling of the first film layer, thereby enhancing a bonding force between the first film layer and the base material of the sliding slot and a bonding force between the first film layer and the second film layer. For the foregoing considerations, a D50 particle size of the silicon dioxide may be controlled to be within a range of 1 to 3 mm.

A larger thickness of the silicon dioxide layer is more conducive to improving abrasion resistance of the lubricating film layer, but an excessively large thickness is not conducive to reducing a surface friction coefficient of the lubricating film layer.

A larger thickness of the perfluoropolyether silane layer is more conducive to reducing sliding resistance of the sliding member in the lubricating film layer. However, if the thickness of the second film layer is excessively large, unnecessary manufacturing costs are increased and a solvent of the perfluoropolyether silane layer may easily fall off from the surface of the silicon dioxide layer.

For a comprehensive consideration of manufacturing costs and abrasion resistance of the lubricating film layer and improvement of sliding performance, the thickness of the first film layer is preferably controlled to be 10 to 25 nm, and the thickness of the second film layer is preferably controlled to be 20 to 45 nm.

More preferably, the thickness of the first film layer is controlled to be 20 nm to 25 nm, and the thickness of the second film layer is preferably controlled to be 40 nm to 45 nm.

In a specific implementation, the thickness of the first film layer may be specifically 10 nm, 15 nm, 20 nm, 21 nm, 23 nm, 25 nm, or within a range including any two thereof.

In a specific implementation, the thickness of the second film layer may be specifically 20 nm, 30 nm, 40 nm, 41 nm, 43 nm, 45 nm, or within a range including any two thereof.

According to a second aspect of this application, a method for preparing the foregoing motor is provided and includes the following step: in a vacuum condition, performing evaporation deposition of a raw material including the perfluoropolyether silane on the bonding surface to form the lubricating film layer.

Vacuum evaporation deposition is a process in which the raw material that composes the lubricating film layer is heated by using an evaporation source so that the raw material is vaporized and evaporates, and then the gaseous raw material is deposited on the surface of the sliding slot to form the lubricating film layer. In comparison with a conventional way of performing immersion to apply lubricating oil on the surface of the sliding member or applying the lubricating oil through a dispenser, a brush, or coating, the lubricating film layer formed through vacuum evaporation deposition has better uniformity and lower surface energy, to obviously improve sliding performance of the surface of the sliding slot, so that the sliding member has lower sliding resistance with a smoother sliding effect.

In a vacuum coating process, a vacuum degree is an important factor that affects quality of the film layer. Specifically, a higher vacuum degree can prevent the surface of the sliding slot from being oxidized by air or being infiltrated with impurities, thereby helping improve a bonding force between the lubricating film layer and the sliding slot.

In a specific implementation, the vacuum evaporation deposition is performed at a vacuum degree of 1.0×10⁻³ to 3.0×10⁻³ Pa. The foregoing vacuum condition is conducive to preparing a lubricating film layer with high purity and a strong bonding force.

In a specific implementation, the foregoing raw material further includes silicon dioxide in addition to the perfluoropolyether silane, and performing evaporation deposition of the raw material including the perfluoropolyether silane on the bonding surface to form the lubricating film layer includes the following steps:
heating the silicon dioxide by using a first evaporation source for the silicon dioxide to evaporate and form silicon dioxide gas molecules, and depositing the silicon dioxide gas molecules on the bonding surface to form the first film layer;
heating the perfluoropolyether silane by using a second evaporation source for the perfluoropolyether silane to evaporate and form perfluoropolyether silane gas molecules, and depositing the perfluoropolyether silane gas molecules on the surface of the first film layer to form the second film layer; and
forming the lubricating film layer by the first film layer and the second film layer together.

The foregoing process of preparing the lubricating film layer is described by using an example in which the surface of the sliding slot serves as the bonding surface. FIG. 7 is a diagram of a structure of a sliding slot without surface treatment. The first film layer may be formed after evaporation deposition of the silicon dioxide is performed on the surface of the sliding slot 11 without surface treatment. FIG. 8 is a diagram of a structure of a sliding slot after a first film layer is formed through evaporation deposition. As shown in FIG. 8, the first film layer 13a is formed on the surface of the sliding slot. Further, the second film layer may be obtained by continuing to perform evaporation deposition on the surface of the first film layer 13a. As shown in FIG. 6, the second film layer 13b is formed on the surface of the first film layer 13a, and the first film layer 13a and the second film layer 13b together form the lubricating film layer 13.

Types of the first evaporation source and the second evaporation source are not specifically limited in this application. The first evaporation source and the second evaporation source may be electron guns or evaporation boats commonly used in the art, and types of the first evaporation source and the second evaporation source may be the same or different. The raw material is heated by using the evaporation sources, so that the raw material evaporates and becomes uniform vapor, and a uniform film layer can be formed after condensation.

When an evaporation boat is used as the first evaporation source or the second evaporation source, the raw material to evaporate may be stored in the evaporation boat, and then heated.

When an electron gun is used as the first evaporation source or the second evaporation source, the raw material to evaporate may be stored in an open high-temperature resistant vessel, for example, a crucible, and then the electron gun is applied for the raw material to evaporate.

Further, an evaporation rate of the silicon dioxide is 2 to 8 Å/s, and an evaporation rate of the perfluoropolyether silane is 3 to 10 Å/s.

The evaporation rate affects uniformity and efficiency of space filling of the film layer. The lower the evaporation rate, the better the uniformity of the prepared film layer and the higher the efficiency of space filling of the prepared film layer. The first film layer is a silicon dioxide layer, which can improve abrasion resistance of the lubricating film layer. If the film layer structure is too loose, it is not conducive to improving the abrasion resistance. If the film layer structure is too compact, the perfluoropolyether silane is not easy to infiltrate and it is not conducive to reducing the friction coefficient of the lubricating film layer. Similarly, the second film layer cannot be too loose or too compact. Otherwise, the lubricating film layer can hardly have excellent abrasion resistance and low friction resistance.

When evaporation is performed on the raw material of the first film layer and the raw material of the second film layer at evaporation rates within the foregoing numerical ranges, the lubricating film layer can have both low friction resistance and excellent abrasion resistance.

Evaporating temperatures of the raw material of the first film layer and the raw material of the second film layer are not particularly limited in this application, provided that the raw material of the first film layer and the raw material of the second film layer can evaporate and are not to be decomposed.

A distance between the evaporation source and the bonding surface for evaporation deposition is also an important factor affecting the quality of the lubricating film layer. When the distance between the evaporation source and the bonding surface for evaporation deposition is excessively large, energy of gas molecules that are incident to the bonding surface is low and a small quantity of gas molecules migrate to the bonding surface, causing a decrease in flatness of a thin film and uneven distribution of the thin film.

The inventor finds through research that, when the distance between the evaporation source and the bonding surface for evaporation deposition is less than or equal to 900 mm, it is beneficial to preparing a lubricating film layer with a flat and uniform surface.

A vacuum evaporation deposition process in this application may be completed in a vacuum coating machine. The vacuum evaporation deposition machine includes a vacuum chamber, where a motor assembly including the bonding surface may be placed in a cavity of the vacuum chamber to complete the vacuum evaporation deposition process.

In a preferred implementation, a temperature of the vacuum chamber is 25°C to 60°C, and the temperature of the vacuum chamber is also a temperature of the bonding surface. Within the foregoing temperature range, it is more conducive to uniform condensation of the raw material for evaporation deposition on the bonding surface. Temperature setting of the vacuum chamber mainly depends on heat tolerance of the material of the bonding surface and the material of the lubricating film layer. If the temperature is too high, the material of the lubricating film layer is decomposed or volatilizes. In this case, it is unfavorable for the material to bring lubrication performance into play, and it is difficult to effectively reduce friction resistance between the lubricating film layer and the sliding member.

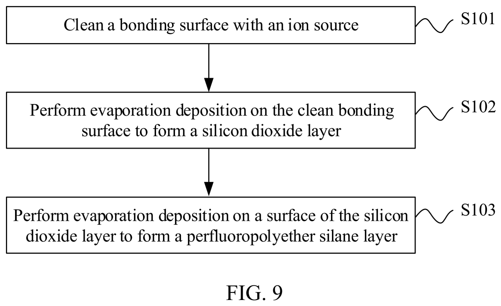

Further, before the vacuum evaporation deposition of the raw material of the lubricating film layer is performed on the bonding surface, a process of cleaning the bonding surface with an ion source is further included. FIG. 9 is a flowchart of a method for preparing a lubricating film layer according to an embodiment of this application. As shown in FIG. 9, the preparation of the lubricating film layer includes the following steps.

S101: Clean the bonding surface with the ion source.

S102: Perform evaporation deposition on the clean bonding surface to form the silicon dioxide layer.

S103: Perform evaporation deposition on the surface of the silicon dioxide layer to form the perfluoropolyether silane layer.

The process of cleaning with the ion source in step S101 may be completed in a vacuum coating machine equipped with an ion source assembly. Specifically, the sliding member and/or the sliding slot including the bonding surface may be placed in a cavity of a vacuum chamber, and a vacuum degree of the vacuum evaporation deposition machine is set to the vacuum degree for evaporation deposition. After a vacuum degree of the cavity of the vacuum chamber reaches the specified vacuum degree, argon or nitrogen is let in, a radio frequency power supply is employed to stimulate the argon or nitrogen to generate a high-energy plasma (namely, the ion source) which then bombards the bonding surface. After being bombarded by the ion source, the bonding surface may be cleaned.

The cleaning with the ion source can effectively remove organic substances and oxides from the bonding surface to avoid contamination, and enhance adhesion of the bonding surface. In addition, the bonding surface may be further etched and modified, so that the bonding surface is coarsened, to remove a weak boundary layer and enhance roughness of the bonding surface, thereby facilitating evaporation deposition to form the lubricating film layer.

In a specific implementation, power for the cleaning with the ion source is 250 W and cleaning time is 1 to 3 minutes to fully clean the bonding surface.

For an evaporation deposition process of the silicon dioxide layer and the perfluoropolyether silane layer in steps S102 and S103, refer to the foregoing step descriptions. Details are not described herein.

Further, before evaporation deposition is performed to form the lubricating film layer, a jig should be used to shade other portions than the bonding surface; and after the evaporation deposition is completed, a process of assembly of the sliding member and the sliding slot is further included.

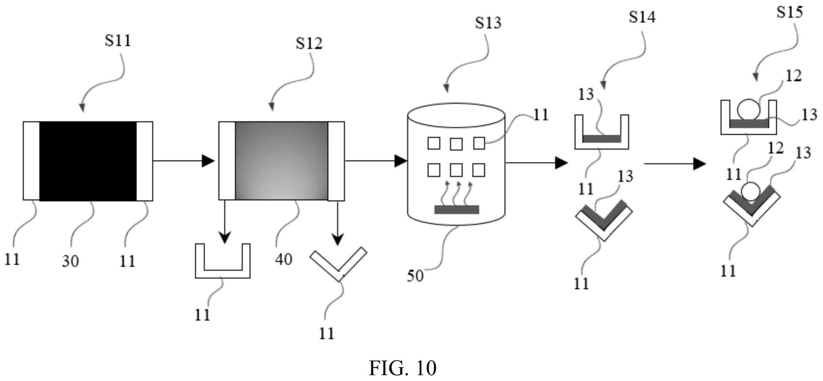

The evaporation deposition process and the process of assembly of the sliding member and the sliding slot are described by using an example in which the surface of the sliding slot serves as the bonding surface. FIG. 10 is a diagram of an evaporation deposition process of a lubricating film layer and a process of assembly of a sliding member and a sliding slot according to an embodiment of this application. As shown in FIG. 10, the evaporation deposition process of the lubricating film layer and the process of assembly of the sliding member and the sliding slot include the following steps.

S11: Place a motor assembly 30 including a sliding slot 11 onto a tray.

S12: Use a jig 40 to shade other portions than a surface of the sliding slot 11.

The sliding slot 11 may be a U-shaped sliding slot or a V-shaped sliding slot.

S13: Place the motor assembly 30 into a vacuum chamber of a vacuum coating machine 50, and perform evaporation deposition of a raw material of the lubricating film layer on the surface of the sliding slot 11 in batches, to form the lubricating film layer.

In this step, the batches mean a step in which a plurality of motor assemblies 30 may be placed into the vacuum coating machine 50 at the same time for coating in batches to improve coating efficiency.

S14: Take out the motor assembly 30 on which vacuum evaporation deposition has been completed.

It can be learned from the figure that, in this case, a lubricating film layer 13 is already formed on the surface of the sliding slot 11.

S15: Automatically assemble the sliding member 12 into a groove of the sliding slot 11.

According to a third aspect of embodiments of this application, a camera assembly is provided. The camera assembly includes the foregoing motor. In addition, the camera assembly further includes a lens. The motor may be sleeved outside the lens, and is configured to drive the lens to move.

According to a fourth aspect of embodiments of this application, an electronic device is provided, including the foregoing camera assembly. The electronic device may be a device such as a mobile phone, a tablet computer, a personal digital assistant, a monitor, a camera, a personal computer, a notebook computer, a wearable device, or a car event data recorder.

It may be understood that the electronic device further includes a housing, and a lens hole is provided at a position that is on the housing and that corresponds to a lens of the camera assembly, so that light can be shot into the camera assembly through the lens hole, to implement a photographing function of the electronic device.

The following describes the motor provided in this application in detail by using specific embodiments.

### Embodiment 1

This embodiment provides a motor, including a motor stator and a motor rotor. Structures of the motor stator and the motor rotor are shown in FIG. 3. The motor stator 20 includes a fixing slot 21 and a sliding member 12 that is fastened in the fixing slot 21. The motor rotor 10 includes a sliding slot 11. The sliding slot 11 is made of a plastic material. The sliding member 12 is a ceramic sliding shaft. A lubricating film layer is provided on a surface of the sliding slot 11.

This embodiment further provides a method for preparing the lubricating film layer, including the following steps.
(1) Place the sliding slot onto a tray, use a jig to shade other portions than the surface of the sliding slot, and then put the sliding slot into a vacuum chamber of a vacuum coating machine.
(2) Set a vacuum degree of the vacuum chamber to 1.0×10⁻³ Pa and a temperature of the vacuum chamber to 25°C, inject argon into the vacuum chamber, and clean the surface of the sliding slot with an ion source at 250 W power for 1 minute.
(3) Keep the vacuum degree and the temperature of the vacuum chamber unchanged, heat silicon dioxide whose D50 particle size is 1.5 mm by using a tungsten evaporation boat to sublimate the silicon dioxide into silicon dioxide gas molecules, and deposit the sublimated silicon dioxide gas molecules on the surface of the sliding slot to obtain a first film layer.
   In this step, a distance between the tungsten evaporation boat and the surface of the sliding slot is 900 mm, an evaporation rate of the silicon dioxide is 5 Å/s, and a thickness of the first film layer formed through evaporation deposition is 20 nm.
(4) Keep the vacuum degree and the temperature of the vacuum chamber unchanged, heat (CH₃O)₂Si-PFPE (with D-type PFPE) by using the tungsten evaporation boat to sublimate the (CH₃O)₂Si-PFPE (with D-type PFPE) into gas molecules, and deposit the sublimated gas molecules on the first film layer to obtain a second film layer, where the first film layer and the second film layer together form the lubricating film layer.

In this step, a distance between the tungsten evaporation boat and a surface of the first film layer is 900 mm, an evaporation rate of the (CH₃O)₂Si-PFPE (with D-type PFPE) is 8 Å/s, and a thickness of the second film layer formed through evaporation deposition is 40 nm.

### Embodiment 2

This embodiment provides a motor, and a structure of the motor is consistent with that in Embodiment 1. A method for preparing a lubricating film layer is also basically consistent with that in Embodiment 1, except for the following difference.

Change the temperature of the vacuum chamber from 25°C to 60°C.

### Embodiment 3

This embodiment provides a motor, and a structure of the motor is consistent with that in Embodiment 1. A method for preparing a lubricating film layer is also basically consistent with that in Embodiment 1, except for the following difference.

Change the temperature of the vacuum chamber from 25°C to 100°C.

### Embodiment 4

This embodiment provides a motor, and a structure of the motor is consistent with that in Embodiment 1. A method for preparing a lubricating film layer is also basically consistent with that in Embodiment 1, except for the following difference.

Replace the perfluoropolyether silane (CH₃O)₂Si-PFPE (K-type) with (CH₃O)₂Si-PFPE (D-type).

### Embodiment 5

This embodiment provides a motor, and a structure of the motor is consistent with that in Embodiment 1. A method for preparing a lubricating film layer is also basically consistent with that in Embodiment 1, except for the following difference.

Replace the perfluoropolyether silane (CH₃O)₂Si-PFPE (K-type) with (CH₃O)₂Si-PFPE (Y-type).

### Embodiment 6

This embodiment provides a motor, and a structure of the motor is consistent with that in Embodiment 1. A method for preparing a lubricating film layer is also basically consistent with that in Embodiment 1, except for the following difference.

Replace the perfluoropolyether silane (CH₃O)₂Si-PFPE (K-type) with (CH₃O)₂Si-PFPE (Z-type).

### Embodiment 7

This embodiment provides a motor, and a structure of the motor is consistent with that in Embodiment 1. A method for preparing a lubricating film layer is also basically consistent with that in Embodiment 1, except for the following difference.

Replace the silicon dioxide whose D50 size is 1.5 mm with the silicon dioxide whose D50 size is 5 mm.

### Embodiment 8

This embodiment provides a motor, and a structure of the motor is consistent with that in Embodiment 1. A method for preparing a lubricating film layer is also basically consistent with that in Embodiment 1, except for the following difference.

A thickness of the second film layer formed through evaporation deposition is 10 nm.

### Embodiment 9

This embodiment provides a motor, and a structure of the motor is consistent with that in Embodiment 1. A method for preparing a lubricating film layer is also basically consistent with that in Embodiment 1, except for the following difference.

A thickness of the second film layer formed through evaporation deposition is 20 nm.

### Embodiment 10

This embodiment provides a motor, and a structure of the motor is consistent with that in Embodiment 1. A method for preparing a lubricating film layer is also basically consistent with that in Embodiment 1, except for the following difference.

A thickness of the second film layer formed through evaporation deposition is 60 nm.

### Embodiment 11

This embodiment provides a motor, and a structure of the motor is consistent with that in Embodiment 1. A method for preparing a lubricating film layer is also basically consistent with that in Embodiment 1, except for the following difference.

In this embodiment, step (3) is omitted, and step (4) is replaced with the following step: Keep the vacuum degree and the temperature of the vacuum chamber unchanged, heat (CH₃O)₂Si-PFPE (with D-type PFPE) by using a tungsten evaporation boat to sublimate the (CH₃O)₂Si-PFPE (with D-type PFPE) into gas molecules, and deposit the sublimated gas molecules on a cleaned surface of the sliding slot to obtain a second film layer, where the second film layer is the lubricating film layer. In this step, a distance between the tungsten evaporation boat and the cleaned surface of the sliding slot is 900 mm, an evaporation rate of the (CH₃O)₂Si-PFPE (with D-type PFPE) is 8 Å/s, and a thickness of the second film layer formed through evaporation deposition is 40 nm.

### Embodiment 12

This embodiment provides a motor, and a structure of the motor is consistent with that in Embodiment 1. A method for preparing a lubricating film layer is also basically consistent with that in Embodiment 1, except for the following difference.

A thickness of the first film layer formed through evaporation deposition is 10 nm.

### Embodiment 13

This embodiment provides a motor, and a structure of the motor is consistent with that in Embodiment 1. A method for preparing a lubricating film layer is also basically consistent with that in Embodiment 1, except for the following difference.

A thickness of the first film layer formed through evaporation deposition is 50 nm.

### Embodiment 14

This embodiment provides a motor, and a structure of the motor is consistent with that in Embodiment 1. A method for preparing a lubricating film layer is also basically consistent with that in Embodiment 1, except for the following difference.

A thickness of the first film layer formed through evaporation deposition is 10 nm, and a thickness of the second film layer formed through evaporation deposition is 10 nm.

### Embodiment 15

This embodiment provides a motor, and a structure of the motor is consistent with that in Embodiment 1. A method for preparing a lubricating film layer is also basically consistent with that in Embodiment 1, except for the following difference.

An evaporation rate of the (CH₃O)₂Si-PFPE (with D-type PFPE) is 3 Å/s.

### Embodiment 16

This embodiment provides a motor, and a structure of the motor is consistent with that in Embodiment 1. A method for preparing a lubricating film layer is also basically consistent with that in Embodiment 1, except for the following difference.

An evaporation rate of the (CH₃O)₂Si-PFPE (with D-type PFPE) is 10 Å/s.

### Embodiment 17

This embodiment provides a motor, and a structure of the motor is consistent with that in Embodiment 1. A method for preparing a lubricating film layer is also basically consistent with that in Embodiment 1, except for the following difference.

An evaporation rate of the silicon dioxide is 3 Å/s.

### Embodiment 18

This embodiment provides a motor, and a structure of the motor is consistent with that in Embodiment 1. A method for preparing a lubricating film layer is also basically consistent with that in Embodiment 1, except for the following difference.

An evaporation rate of the silicon dioxide is 8 Å/s.

### Comparative Example 1

In this comparative example, a motor is provided and a structure of the motor is consistent with that in Embodiment 1. A lubricating film layer of the motor is formed by coating polytetrafluoroethylene on a surface of a sliding slot. A specific preparation method includes the following steps.
(1) After placing the sliding slot onto a tray, use a jig to shade other portions than the surface of the sliding slot.
(2) Coat the surface of the sliding slot with the polytetrafluoroethylene by using a sprayer to form a polytetrafluoroethylene lubricating film layer with a thickness of 40 nm.

### Comparative Example 2

In this comparative example, a motor is provided and a structure of the motor is consistent with that in Embodiment 1. A difference lies in that, a lubricating film layer in this comparative example is formed on a surface of a sliding member, and a specific preparation process is as follows: Mix 16 wt% D-type perfluoropolyether base oil, 4 wt% thickener polytetrafluoroethylene, and 80 wt% perfluoroalkane for emulsification to form a perfluoropolyether lubricant; and apply the perfluoropolyether lubricant to a surface of a ceramic sliding shaft (the sliding member 12), where a lubricating film layer with a thickness of about 20 µm is formed after the perfluoroalkane volatilizes.

### Test Case

The lubricating film layers in the foregoing embodiments and comparative examples are tested with the following parameters.

### 1. Coefficient of static friction and coefficient of kinetic friction

Test method: Use a Dage push-pull testing machine to fasten the motor stator and the sliding shaft with tooling and a jig, attach a counterweight block to the surface of the motor rotor, apply a vertical normal force F_{N} to push the motor rotor at a constant speed so that the sliding slot of the motor rotor and the sliding shaft are in contact and slide by 200 to 1000 µm at a speed of 300 to 500 µm/s, and record a thrust F (that is, a magnitude of a friction force f under different normal forces) required under different normal forces. Friction coefficient = Thrust F/Normal force F_{N}.

Calculate the coefficient of static friction by using a thrust F₁ that is recorded at a moment when the sliding slot and the sliding shaft start sliding and the vertical normal force F_{N}: Coefficient of static friction = F₁/F_{N}.

Calculate the coefficient of kinetic friction by using a thrust F₂ that is required after the sliding slot and the sliding shaft move at a stable and uniform speed and the vertical normal force F_{N}: Coefficient of kinetic friction = F₂/F_{N}.

Test results of the coefficient of static friction and the coefficient of kinetic friction are shown in Table 1.

### 2. Abrasion resistance

Test method: Use the Dage push-pull testing machine to perform reciprocating friction for 1000 times, and calculate a change rate of a friction coefficient at 1000^{th} reciprocating friction relative to a friction coefficient at 1^{st} reciprocating friction.

If the change rate of the friction coefficient is less than 5% following 1000 times of reciprocating friction, the abrasion resistance is at a level of +++.

If the change rate of the friction coefficient is 10% to 30% following 1000 times of reciprocating friction, the abrasion resistance is at a level of ++.

If the change rate of the friction coefficient is greater than 30% but not greater than 50% following 1000 times of reciprocating friction, the abrasion resistance is at a level of +.

If the change rate of the friction coefficient is greater than 50% following 1000 times of reciprocating friction, the abrasion resistance is at a level of -.

Test results of the abrasion resistance are shown in Table 1.

### 3. Surface energy

Test method: Apply a force to draw blue lines on the surfaces of the sliding slots in Embodiment 1, Embodiment 2, Comparative Example 1, and Comparative Example 2 separately by using a blue oil-based marker available on the market, and observe ink marks on the surfaces of the sliding slots. In the same manner, apply a force to draw a blue line on a surface of a sliding slot for which no any treatment has been performed by using the blue oil-based marker for blank control. Qualitatively evaluate surface energy of the sliding slots based on shrinkage of the blue ink lines on the surfaces of the sliding slots. Evaluation criteria are as follows.

If the blue ink shrinks into a dot, the surface energy is at a level of A.

If the blue ink shrinks into a dashed line, the surface energy is at a level of B.

If the blue ink scarcely shrinks and the blue ink on the surface of the sliding slot almost forms a line, the surface energy is at a level of C.

If the blue ink does not shrink and a continuous blue line is formed on the surface of the sliding slot, the surface energy is at a level of D.

The surface energy is sorted in descending order of levels as follows: D > C > B > A.

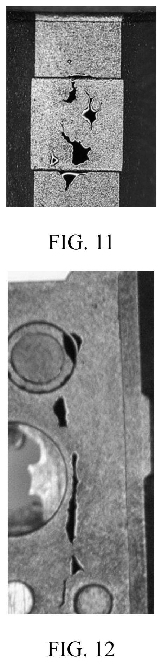

FIG. 11 is a qualitative test diagram of surface energy of a lubricating film layer according to Embodiment 1 of this application. It can be learned from FIG. 11 that, in Embodiment 1, blue ink on a surface of the lubricating film layer formed through vacuum evaporation deposition of perfluoropolyether silane shrinks into a dot, where the surface energy is at a level of A.

FIG. 12 is a qualitative test diagram of surface energy of a lubricating film layer in Comparative Example 1 according to this application. It can be learned from FIG. 12 that blue ink on a surface of the lubricating film layer formed through polytetrafluoroethylene coating shrinks into a dashed line, where the surface energy is at a level of B.

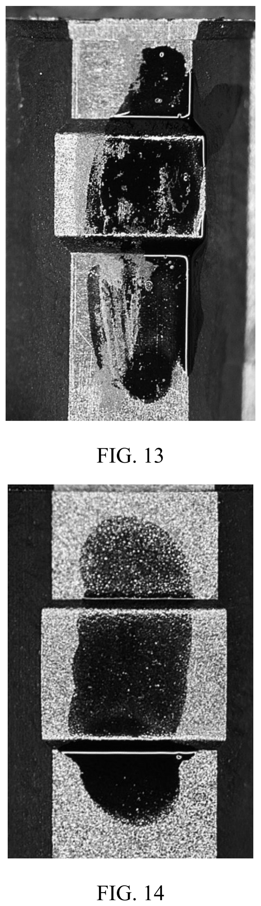

FIG. 13 is a qualitative test diagram of surface energy of a surface of a sliding slot in Comparative Example 2 according to this application. It can be learned from FIG. 13 that, after a lubricant is applied, a grease layer is formed on a surface of a ceramic sliding shaft, and blue ink on the surface of the sliding slot scarcely shrinks after the ceramic sliding shaft rolls on the surface of the sliding slot but forms a solid line, where the surface energy is at a level of C.

FIG. 14 is a qualitative test diagram of surface energy of a surface of a sliding slot without lubrication treatment. It can be learned from FIG. 14 that, blue ink on the surface of the sliding slot without lubrication treatment does not shrink at all but forms a continuous blue solid line, where the surface energy is at a level of D.

It can be learned by comparing FIG. 11 to FIG. 14 that, compared with manners such as applying a perfluoropolyether lubricant and coating polytetrafluoroethylene, the lubricating film layer formed through vacuum evaporation deposition of perfluoropolyether silane in this application can obviously reduce the surface energy of the surface of the sliding slot.

**Table 1**

| | Coefficient of static friction | Coefficient of kinetic friction | Abrasion resistance |
|---|---|---|---|
| Embodiment 1 | 0.05 | 0.03 | +++ |
| Embodiment 2 | 0.05 | 0.03 | +++ |
| Embodiment 3 | 0.10 | 0.06 | +++ |
| Embodiment 4 | 0.08 | 0.04 | +++ |
| Embodiment 5 | 0.12 | 0.05 | +++ |
| Embodiment 6 | 0.10 | 0.04 | +++ |
| Embodiment 7 | 0.06 | 0.04 | ++ |
| Embodiment 8 | 0.10 | 0.06 | +++ |
| Embodiment 9 | 0.08 | 0.05 | +++ |
| Embodiment 10 | 0.05 | 0.03 | +++ |
| Embodiment 11 | 0.05 | 0.03 | + |
| Embodiment 12 | 0.05 | 0.03 | ++ |
| Embodiment 13 | 0.10 | 0.05 | ++++ |
| Embodiment 14 | 0.10 | 0.06 | + |
| Embodiment 15 | 0.06 | 0.04 | ++++ |
| Embodiment 16 | 0.05 | 0.03 | ++ |
| Embodiment 17 | 0.07 | 0.05 | ++++ |
| Embodiment 18 | 0.05 | 0.03 | ++ |
| Comparative Example 1 | 0.11 | 0.08 | +++ |
| Comparative Example 2 | 0.11 | 0.06 | +++ |

The following conclusions can be drawn from Table 1.
(1) It can be learned from comparison of Embodiment 1 to Embodiment 3 that, temperature setting of the vacuum chamber mainly depends on heat tolerance of the material of the sliding slot and the material of the lubricating film layer. Within the tolerance (25°C and 60°C) of the material of the sliding slot and the material of the lubricating film layer, the lubrication performance and the abrasion resistance of the prepared lubricating film layer are not obviously affected. However, when the temperature specified for the vacuum chamber is too high and reaches 100°C, the material of the lubricating film layer volatilizes, resulting in degradation of the lubricating performance.
(2) It can be learned from comparison between Embodiment 1 and Embodiment 4 to Embodiment 6 that, effects of friction reduction are: K-type perfluoropolyether silane > D-type perfluoropolyether silane > Z-type perfluoropolyether silane ≈ Y-type perfluoropolyether silane. A reason may be that, the surface energy reduces to a greater degree as the quantity of fluorine atom substitutions increases, and a size of -CF₃ is greater than that of -CF₂-, with a more compact structure and a better effect of surface energy reduction. The K-type PFPE has highest content of trifluoromethyl, and accordingly has a best effect of friction reduction. In addition, a larger molecular weight of the perfluoropolyether indicates a longer fluorine-containing chain segment, larger coverage of the fluorine-containing chain segment in the film layer, a more compact surface arrangement, and a better effect of surface energy reduction. The molecular weight is: D-type > Z-type ≈ Y-type. Therefore, ultimate effects of friction reduction are: K-type > D-type > Z-type ≈ Y-type.
(3) It can be learned from comparison between Embodiment 1 and Embodiment 7 that, an excessively large particle size of silicon dioxide results in a worsened effect of friction reduction. A reason may be that, the excessively large particle size causes poor uniformity and poor efficiency of space filling of the film layer, and is not conducive to reduction of surface energy.
(4) It can be learned from comparison between Embodiment 1 and Embodiment 8 to Embodiment 10 that, a larger thickness of the second film layer (the perfluoropolyether silane layer) indicates a better effect of friction reduction. When the thickness of the film is 40 nm, a best effect of friction reduction may be attained. When the thickness of the film continues to increase, the coefficient of static friction and the coefficient of kinetic friction no longer continue to decrease. A reason may be that, when the second film layer is thin, an entire friction surface can hardly be covered, and the effect of friction reduction is poor. However, an excessively large thickness causes weakening of a bonding force between the first film layer and the second film layer, and consequently the second film layer easily falls off.
(5) It can be learned from comparison between Embodiment 1 and Embodiment 11 to Embodiment 13 that, when there is no silicon dioxide layer or the silicon dioxide layer is too thin, friction performance is not obviously affected but abrasion resistance of the second film layer obviously deteriorates; and as the thickness of the silicon dioxide layer increases, the abrasion resistance is higher but the effect of friction reduction deteriorates. A reason may be that silicon dioxide has excellent abrasion resistance. However, when the silicon dioxide layer is too thick, friction cannot be conducted to the base material of the sliding slot and the PFPE, where the PFPE does not play a lubrication effect and friction goes between the base material and the silicon dioxide. However, the silicon dioxide has a high friction coefficient, resulting in worsening of the effect of friction reduction.
(6) It can be learned from comparison between Embodiment 1 and Embodiment 14 that, when the first film layer and the second film layer are both thin, this is unfavorable for the reduction of friction resistance of the lubricating film layer and improvement of the abrasion resistance.
(7) It can be learned from comparison between Embodiment 1 and Embodiment 15 and comparison between Embodiment 1 and Embodiment 16 that, the lower the evaporation rate of the perfluoropolyether silane, the better the abrasion resistance of the lubricating film layer and the higher the evaporation rate of the perfluoropolyether silane, thereby better helping reduce the friction resistance of the surface of the lubricating film layer. A reason may be that the evaporation rate mainly affects the uniformity and compactness of the film layer. The lower the evaporation rate, the higher the efficiency of space filling of the film layer and the better the abrasion resistance. However, an excessively compact arrangement of the molecules is not conducive to maximizing the performance of friction reduction.
(8) It can be learned from comparison between Embodiment 1 and Embodiment 17 and comparison between Embodiment 1 and Embodiment 18 that, a lower evaporation rate of the silicon dioxide indicates higher efficiency of space filling of the obtained silicon dioxide layer, to help improve the abrasion resistance, but at the same time the perfluoropolyether silane is not easy to infiltrate, resulting in worsening of the effect of friction reduction. As the evaporation rate of the silicon dioxide continues to increase, the prepared silicon dioxide layer is too loose, resulting in worsening of abrasion resistance of the lubricating film layer.
(9) It can be learned from comparison between Embodiment 1 and Comparative Example 1 that, compared with the lubricating film layer that is obtained through the polytetrafluoroethylene prepared in a coating manner, the lubricating film layer that is obtained through vacuum evaporation deposition of the perfluoropolyether silane has a lower coefficient of static friction and a lower coefficient of kinetic friction.
(10) It can be learned from comparison between Embodiment 1 and Comparative Example 2 that, the lubricating film layer prepared by applying the lubricant has a coefficient of static friction and a coefficient of kinetic friction obviously higher than those in Embodiment 1, failing to effectively reduce friction resistance of the motor.

In the description of the specification of this application, terms indicating directions or position relationships, such as the terms "inside" and "outside", are based on the directions or position relationships shown in the accompanying drawings and are merely intended for ease of description, but not intended to indicate or imply that an apparatus or a component needs to have a specific direction or be constructed and operated in a specific direction, and therefore cannot be understood as a limitation on this application.

In the description of the specification of this application, a description of a term such as "an embodiment", "some embodiments", "an example", "a specific example", or "some examples" means that a specific feature, structure, material, or characteristic that is described with reference to the embodiment or the example is included in at least one embodiment or example of this application. In this specification, illustrative expressions of the foregoing terms are not necessarily intended for a same embodiment or example. In addition, the described specific feature, structure, material, or characteristic may be combined in any one or more of the embodiments or examples in an appropriate manner. In addition, a person skilled in the art may integrate or combine different embodiments or examples and characteristics of different embodiments or examples described in this specification, provided that they do not conflict with each other.

In the description of the specification of this application, the terms "first", "second", "third", "fourth", and the like (if any) are intended to distinguish between similar objects but do not necessarily indicate a specific order or sequence. It should be understood that the data used in such a way is interchangeable in proper circumstances, so that embodiments of this application described herein, for example, can be implemented in another order than the order illustrated or described herein.

In the description of the specification of this application, the terms "include", "have", and any other variations thereof are intended to cover non-exclusive inclusion. For example, a process, method, system, product, or device that includes a series of steps or units is not necessarily limited to those explicitly listed steps or units, but may include other steps or units that are not explicitly listed or are inherent to the process, method, product, or device.

In the description of the specification of this application, the term "a plurality of" means two or more.

In the description of the specification of this application, the term "and/or" merely describes an association relationship between associated objects and represents that three relationships may exist. For example, A and/or B may represent the following three cases: Only A exists, both A and B exist, and only B exists. In addition, the character "/" in this specification usually indicates an "or" relationship between associated objects, and the character "/" in a formula indicates a "division" relationship between associated objects.

Finally, it should be noted that the foregoing embodiments are merely intended for describing the technical solutions of embodiments of this application rather than limiting the technical solutions. Although embodiments of this application are described in detail with reference to the foregoing embodiments, a person of ordinary skill in the art should understand that modifications may still be made to the technical solutions described in the foregoing embodiments or equivalent replacements may still be made to some or all technical features thereof, without departing from the scope of the technical solutions of embodiments of this application.

## Claims

1. A motor, comprising a motor stator and a motor rotor, wherein the motor rotor comprises a sliding slot and a sliding member that is at least partially located in the sliding slot, a surface of the sliding slot and/or a surface of the sliding member serve/serves as a bonding surface, a lubricating film layer is provided on the bonding surface, and composition of the lubricating film layer comprises perfluoropolyether silane.

2. The motor according to claim 1, wherein the lubricating film layer comprises a first film layer and a second film layer that are provided in a laminated manner, the first film layer is provided on a surface of the bonding surface, and the second film layer is provided on a surface of the first film layer; and
the first film layer is a silicon dioxide layer, and the second film layer is a perfluoropolyether silane layer.

3. The motor according to claim 2, wherein a thickness of the first film layer is 10 to 25 nm.

4. The motor according to claim 2, wherein a thickness of the second film layer is 20 to 45 nm.

5. The motor according to claim 2, wherein a D50 particle size of silicon dioxide in the first film layer is 1 to 3 mm.

6. A method for preparing the motor according to any one of claims 1 to 5, comprising the following step:
in a vacuum condition, performing evaporation deposition of a raw material comprising the perfluoropolyether silane on the bonding surface to form the lubricating film layer.

7. The preparation method according to claim 6, wherein the evaporation deposition is performed at a vacuum degree of 1.0×10⁻³ to 3.0×10⁻³ Pa.

8. The preparation method according to claim 6 or 7, wherein the raw material further comprises silicon dioxide, and performing evaporation deposition of the raw material comprising the perfluoropolyether silane on the bonding surface to form the lubricating film layer comprises the following steps:
heating the silicon dioxide by using a first evaporation source for the silicon dioxide to evaporate and form silicon dioxide gas molecules, and depositing the silicon dioxide gas molecules on the bonding surface to form the first film layer;
heating the perfluoropolyether silane by using a second evaporation source for the perfluoropolyether silane to evaporate and form perfluoropolyether silane gas molecules, and depositing the perfluoropolyether silane gas molecules on the surface of the first film layer to form the second film layer; and
forming the lubricating film layer by the first film layer and the second film layer together.

9. The preparation method according to claim 8, wherein an evaporation rate of the silicon dioxide is 2 to 8 Å/s.

10. The preparation method according to claim 8 or 9, wherein an evaporation rate of the perfluoropolyether silane is 3 to 10 Å/s.

11. A camera assembly, comprising the motor according to any one of claims 1 to 5.

12. An electronic device, comprising the camera assembly according to claim 11.
